# EUROPEAN PATENT APPLICATION

(11) **EP 4 845 029 A1**
(43) Date of publication of application: **25.11.2026**
(21) Application number: 26179265.9
(22) Date of filing: 18.05.2026
(51) Int. Cl.: H03F 3/45, H03H 11/12, H03M 1/00

(54) **MULTIPLE-MODE SIGNAL FILTER SYSTEM**

(30) Priority: 21.05.2025 US 202519215099
(71) Applicant: Analog Devices, Inc., Wilmington, MA 01887 (US)
(72) Inventor: HAMILTON, Brian D., Wilmington, 01887 (US); AKSIN, Devrim Yilmaz, Wilmington, 01887 (US)
(74) Representative: Wallin, Nicholas James

(57) **Abstract**

A multiple-mode signal processing system includes a dual-input filter with first and second amplifier circuits configured to process differential signals through two distinct signal paths. In a first mode, primary differential signals are received at non-inverting amplifier inputs while inverting inputs are shunted to respective outputs. In a second mode, the non-inverting inputs receive a DC voltage while secondary differential signals are processed through inverting inputs. The system enables high-precision signal processing in both modes by routing signals through different amplifier input terminals and using separate passive component networks for each mode.

## Description

### PRIORITY CLAIM

This European patent application claims priority from United States patent application No. 19/215099, filed 21st May 2025.

### FIELD OF THE DISCLOSURE

This disclosure relates generally to integrated circuits and signal filters.

### BACKGROUND

In various electronics applications, an analog-to-digital converter (ADC) can translate analog electrical signals representing real-world phenomenon, e.g., light, sound, temperature, or pressure, to a digital output signal for further processing in the digital domain. For example, in precision measurement systems, electronics can be provided with one or more sensors to make measurements and generate analog signals. The analog signals can be provided to an ADC to generate a digital output signal for further processing.

ADCs can be used in broadband communication systems, audio systems, or other receiver systems, among others. ADCs can be used in a broad range of applications such as communications, energy, healthcare, instrumentation and measurement, motor and power control, industrial automation or aerospace, among other applications.

### SUMMARY

A dual-input filter circuit enables selective processing of either primary input signals or secondary input signals through independent signal paths. The filter circuit includes amplifier circuits configured to process differential signals using different input terminals for each mode of operation. In a main or normal operating mode, primary signals can be received using non-inverting amplifier inputs while inverting inputs are shunted to respective amplifier outputs, enabling high-bandwidth, low-noise signal processing. In a second operating mode, the non-inverting inputs of the amplifier circuits can receive matched DC voltages while secondary signals are processed through inverting inputs. The respective signal paths for the primary and secondary signals allow for independent optimization of linearity and noise characteristics for each mode.

In an example, a multiple-mode signal filter system can be used for selective processing of differential signals. In a first mode, differential primary signals can be received at non-inverting inputs of amplifier circuits while first switches provide direct feedback paths between outputs and inverting inputs. In the first mode, second switches remain open to isolate secondary or auxiliary inputs from the filter system. In a second mode, the first switches open and the second switches close to enable processing of differential secondary signals through the inverting inputs, with resistive-capacitive networks providing feedback paths. In the second mode, the non-inverting inputs can receive a common voltage signal to establish desired output common-mode levels. In an example, differential signals can be received from devices under test, and loop-back testing can be enabled by routing digital-to-analog converter outputs through the secondary path of the filter to an analog-to-digital converter.

This Summary is intended to provide an overview of subject matter related to signal filters and related systems and methods. It is not intended to provide an exclusive or exhaustive explanation. The detailed description is included to provide further information.

### BRIEF DESCRIPTION OF THE DRAWINGS

In the drawings, which are not necessarily drawn to scale, like numerals may describe similar components in different views. Like numerals may represent different instances of similar components. The drawings illustrate generally, by way of example, but not by way of limitation, various embodiments discussed in the present document.
FIG. 1 illustrates generally a signal processing system that includes a first filter circuit.
FIG. 2 illustrates generally an example of a Sallen-Key filter circuit.
FIG. 3 illustrates generally an example of a first dual-input filter circuit.
FIG. 4 illustrates generally an example of a second dual-input filter circuit.
FIG. 5 illustrates generally an example of a first method for operating a multiple-mode filter system.
FIG. 6 illustrates generally an example of a second method for operating a multiple-mode filter system.

### DETAILED DESCRIPTION

Anti-alias filter circuits (AAF) can be used before an analog-to-digital converter (ADC) input stage (or front end) to prevent aliasing (due to sampling) of out of band noise/interference into in-band signal range by filtering the out of band frequency content. The AAF can be a low pass filter circuit, a band pass filter circuit, a high pass filter circuit, or other filter. An amplifier can be used to amplify the input signal and drive the ADC front end through the AAF. The filter bandwidth can be a trade-off between settling time desired to meet precision requirements and rejection of out-of-band noise or interference.

A signal processing system that includes or uses the AAF can include a high-resolution receive channel for an ADC. In an example, the ADC is a successive approximation register (SAR) ADC operating at 24-bit precision. The system can include a differential digital-to-analog converter (DAC) force channel. In an example, the DAC circuit can have 20 bits of resolution. A loop-back path can be established between the DAC force channel and the ADC receive channel to enable calibration and characterization of the DAC using the high-resolution ADC. In an example, the signal ranges of the DAC force channel and ADC input differ, and the anti-aliasing filter can be configured to scale and condition the loop-back signal while maintaining the linearity and noise specifications of a primary receive path for the ADC. The filter topologies discussed herein can help achieve this by introducing an auxiliary input path (e.g., a secondary or loop-back path) that operates independently from the main signal path. This multiple-input configuration allows optimization of both the primary receive channel performance and the loop-back signal conditioning without compromising either function.

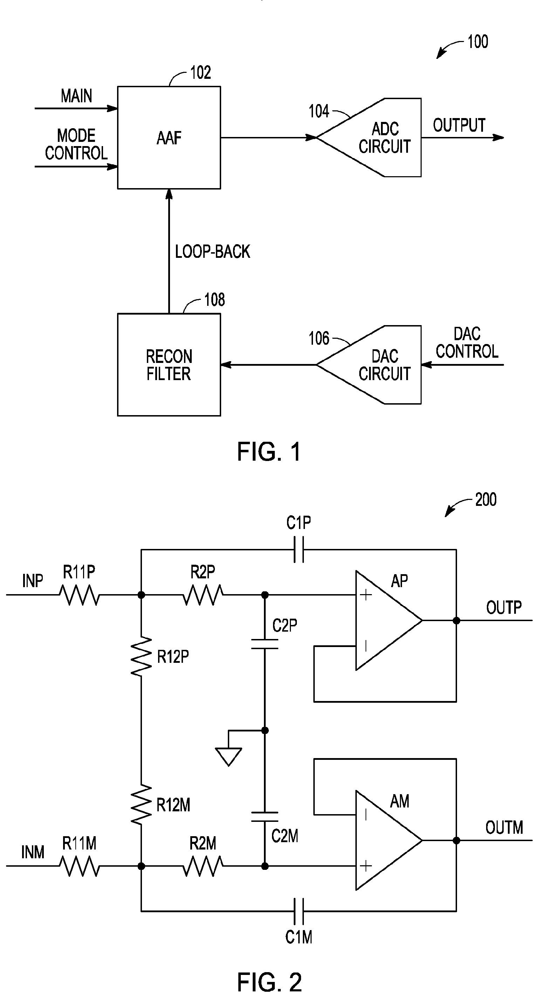

FIG. 1 illustrates generally an example of a signal processing system 100 that includes a first filter circuit 102 and a first analog-to-digital converter (ADC) circuit, or ADC circuit 104. The signal processing system 100 includes a digital-to-analog converter (DAC) circuit or DAC circuit 106 and a reconstruction filter circuit 108. Although drawn single-ended for simplicity, the example of the signal processing system 100 in FIG. 1 can optionally include or use a differential signal processing configuration that can receive and process complementary signal pairs.

The signal processing system 100 receives a main input signal (MAIN) at the first filter circuit 102. The first filter circuit 102 filters and conditions the main input signal before providing it to the ADC circuit 104, which converts the filtered analog signal to a digital output (OUTPUT). In an example, the first filter circuit 102 is an anti-aliasing filter. Input signals (e.g., MAIN) at frequencies higher than the half of the sampling frequency can be shifted down to the first Nyquist band. This frequency translation, commonly referred to as aliasing or folding, results in distortion of the sampled signal. To avoid this distortion, the first filter circuit 102 is used as an anti-aliasing filter to filter out any input signal beyond the Nyquist frequency. Ideally, the anti-aliasing filter is a brick-wall low-pass filter with a bandwidth that is equal to half of the sampling frequency.

The signal processing system 100 includes the DAC circuit 106 that receives digital control signals (DAC CONTROL) and, in response, provides corresponding analog signals. The DAC circuit 106 output passes through a reconstruction filter circuit 108 before being fed back to the first filter circuit 102 as a loop-back signal (LOOP-BACK). This loop-back configuration enables calibration and characterization of the DAC circuit 106 using the high-precision ADC circuit 104. In an example, the reconstruction filter circuit 108 conditions the DAC output signal to match the input requirements of the first filter circuit 102. During normal operation, the first filter circuit 102 processes the main input signal, while in loop-back mode, it processes the conditioned loop-back signal from the reconstruction filter circuit 108.

In an example, the first filter circuit 102 can receive a control signal (MODE CONTROL) that controls the operating mode of the first filter circuit 102. That is, the first filter circuit 102 can be configured to decouple the loop-back signal path from the filter when the control signal indicates a first operating mode for the first filter circuit 102, and the first filter circuit 102 can be configured to receive signals from the loop-back signal path when the control signal indicates a second operating mode for the first filter circuit 102. In an example, the control signal comprises multiple signals that control a state or behavior of one or more switch circuits in the first filter circuit 102 or elsewhere in the signal processing system 100.

There are multiple anti-aliasing filter topologies available. One example of an anti-aliasing filter is the unity gain Sallen-Key low-pass biquad filter. This is a popular topology because it can realize a second order transfer function using one amplifier and it has a noise gain of unity.

FIG. 2 illustrates generally an example of a pseudo-differential Sallen-Key filter circuit 200. The Sallen-Key filter circuit 200 can comprise an example of the first filter circuit 102 from the signal processing system 100 of FIG. 1. The Sallen-Key filter circuit 200 is configured to receive differential input signals INP and INM and, in response, provide filtered differential output signals OUTP and OUTM. The pseudo-differential Sallen-Key filter circuit 200 includes substantially identical or mirrored single-ended Sallen-Key low-pass biquad filter circuit instances with inputs coupled using a resistor network.

A first portion of the Sallen-Key filter circuit 200 is configured to receive a first input signal INP and, in response, provide a first output signal OUTP. The first portion includes two resistors (input resistors R11P and R2P) and two capacitors (C1P and C2P) that establish the transfer function and cut-off frequency of the filter. The first portion includes a first operational amplifier (AP) configured for unity gain, and the amplifier output is connected to the negative input terminal of the first operational amplifier. For the pseudo-differential implementation in FIG. 2, the first portion of the circuit is duplicated with matched components for both positive and negative signal paths. For example, a second portion of the Sallen-Key filter circuit in the example of FIG. 2 includes input resistors R11M and R2M. The input resistors R11M and R2M, together with matched capacitors C1M and C2M, establish the transfer function and cut-off frequency of the negative signal-handling portion of the Sallen-Key filter circuit 200. A resistive circuit including matched filter resistors R12P and R12M couple the input signal paths of the first and second portions of the differential filter circuit. A junction between the series resistors R12P and R12M provides a virtual ground (e.g., at the common mode voltage level).

The Sallen-Key filter circuit is configured to preserve the common-mode voltage of the input signal while attenuating any differential component through resistive networks (e.g., including a positive-side resistive divider that includes resistors R11P and R12P, and a negative-side resistive divider that includes resistors R11M and R12M). The filter realizes a second-order transfer function with a defined cut-off frequency determined by the values of the various resistor and capacitor components. For optimal low-noise performance, resistance characteristics of the filter resistors can be selected to be as small as possible while the capacitors are selected to be as large as possible for a given cut-off frequency. Small input resistors, however, can compromise input current loads and power handling.

In an example, the pseudo-differential Sallen-Key filter circuit 200 can be modified to accommodate multiple inputs. For example, the filter circuit can be configured to enable the loop-back mode shown in FIG. 1. That is, the filter circuit can be configured to accommodate the loop-back signal(s) from the DAC circuit 106 (or elsewhere), such as for calibration or DAC circuit characterization. The filter circuit can have first inputs configured to receive main differential input signals from a main input path, and can have second inputs configured to receive differential auxiliary (e.g., loop-back) signals from a secondary signal path. In an example, characteristics of the main signal inputs can be different than characteristics of the loop-back signal inputs. For example, the respective signals received via the first and second inputs can have different full-scale voltage range, common-mode voltage, or frequency characteristics, among others.

Ideally, a multiple-input filter example can maintain the low-noise characteristics of the main signal path, such as by maintaining the primary input path resistor values low and capacitor values high. In an example, a linearity of the main signal path can be maintained by avoiding use of additional switches or components in the primary signal path. The auxiliary loop-back path can include or use larger-value resistors to minimize coupling between the force channel and receive channel (e.g., keeping interference below the least significant bit (LSB) level of the ADC circuit 104). The loop-back path can include or use scaling components that adjust the loop-back signal range to match the ADC input range. Other circuitry can be provided to condition the common-mode voltage of the loop-back signal to align with input requirements of the ADC circuit 104. In an example, the secondary or loop-back path can have high linearity due in part to larger resistor values that reduce switch-induced distortion. These modifications and others can allow independent optimization of both main and loop-back signal paths while preserving the performance specifications of each filter mode.

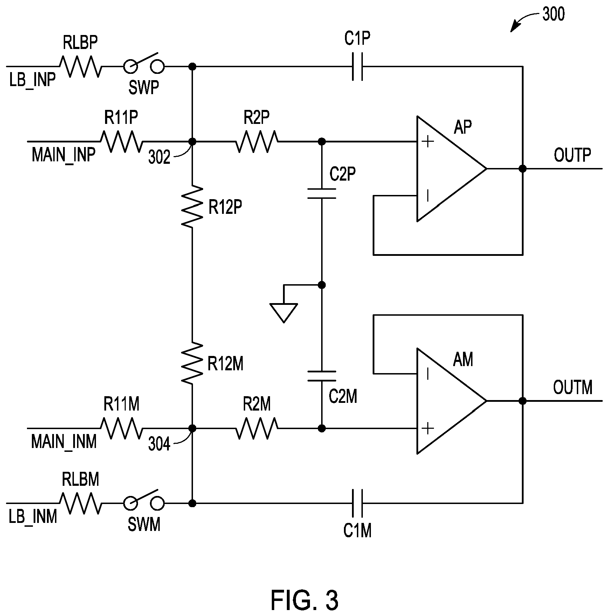

FIG. 3 illustrates generally an example of a first dual-input filter circuit 300. The first dual-input filter circuit 300 is a differential signal filter similar to the Sallen-Key filter circuit 200 of FIG. 2. The first dual-input filter circuit 300 includes a first portion of the filter circuit that comprises a Sallen-Key topology with a first unity gain amplifier AP, and a second portion that comprises a Sallen-Key topology with a second unity gain amplifier AM. Inputs of the first and second portions are coupled by the resistive network R12P and R12M.

The first dual-input filter circuit 300 includes a main input path configured to receive differential main input signals (MAIN_INP, MAIN_INM). The differential main input signals can be coupled via input resistors R11P and R11M to a first input node 302 and a second input node 304, respectively. The first dual-input filter circuit 300 further includes a secondary input path configured to receive differential loop-back input signals (LB_INP, LB_INM). A positive component of the loop-back input signals, LB_INP, can be coupled to the first input node 302 via an input resistor RLBP and a first switch SWP, and a negative component of the loop-back input signals, LB_INM, can be coupled to the second input node 304 via an input resistor RLBM and a second switch SWM. The first and second switches SWP, SWM can be configured to operate together such that both switches are open or closed at the same time. For example, when the first and second switches SWP, SWM are open, then the first dual-input filter circuit 300 is in a first operating mode and loop-back signals are inhibited from reaching the first input node 302 and the second input node 304 of the first dual-input filter circuit 300. When the first and second switches SWP, SWM are closed, then the first dual-input filter circuit 300 is in a second operating mode and loop-back signals are provided to the first input node 302 and the second input node 304.

The first dual-input filter circuit 300, however, has short-comings particularly in extreme dynamic range applications. For purposes of discussion, assume the first and second switches SWP, SWM are ideal. In the first operating mode, the first and switches SWP, SWM, are off or open, and the loop-back input is effectively disconnected from the filter. In this case, the filter output (or the ADC input) common-mode voltage is equal to the common-mode voltage of the main input signals MAIN_INP, MAIN_INM. The components of the input signal are attenuated with the respective resistive dividers formed by R11P/R12P, and R11M/R12M. For a given cut-off frequency, the resistors can be selected to be as small as possible (i.e., with low resistance characteristics) and the capacitors can be selected to be as large as possible (i.e., with high capacitance characteristics) to optimize performance for low noise.

During the loop-back mode, the first and second switches SWP, SWM are on or closed, and the loop-back input path is coupled to the filter. Filter behavior during the loop-back mode can be determined in part based on the resistance value of the loop-back resistors, RLBP and RLBM, and the voltage at the differential inputs of the main signal path.

In an example, the differential component of the main signal path can be 0 V. The common-mode voltage of the main signal path can be set to force the output common-mode voltage to be equal to the desired ADC input common-mode voltage. In other words, when the main signal path receives a DC voltage, the value of the loop-back resistors RLBP, RLBM can be determined based on a desired attenuation from the loop-back inputs to the filter outputs. Ignoring the on-resistance of the switches, and K being the desired gain (e.g., *K* < 1) from the loop-back inputs to the outputs, the resistance of each resistor (i.e., RLBP or RLBM) can be calculated using: $RLB = \frac{1 - K}{K} \frac{{R}_{11} {R}_{12}}{{R}_{11} + {R}_{12}}$

With the value of RLB determined, it is then possible to calculate the main input common-mode voltage as follows: ${VCM}_{IN} = \left(1+\frac{{R}_{11}}{{R}_{LB}}\right) {VCM}_{ADC} - \frac{{R}_{11}}{{R}_{LB}} {VCM}_{LB}$
where *VCM_{IN}, VCM_{ADC},* and *VCM_{LB},* are the main input common-mode voltage, the desired ADC common-mode voltage, and the loop-back signal common-mode voltage, respectively.

The present inventors have recognized that the constraint imposed by the RLB resistance introduces an optimization problem. The parallel equivalent of R11 and R12 is a relatively small resistance to maintain low noise performance, and for a meaningful loop-back input attenuation (e.g., of about a factor of 2), RLB is equal to the parallel equivalent of R11 and R12. Therefore, for a given full-scale ADC range, the loop-back inputs should be configured for current loads that are similar to those of the main path inputs. Under such conditions, it can be difficult to provide switches that are in series with the RLBP, RLBM resistors and maintain linearity. To do so requires physically large switches that, in turn, create OFF state coupling problems due to, for example, large input impedance and capacitance effects. The present inventors have thus recognized that it would be desirable to decouple the loop-back input constraints from the low-noise requirement of the main input.

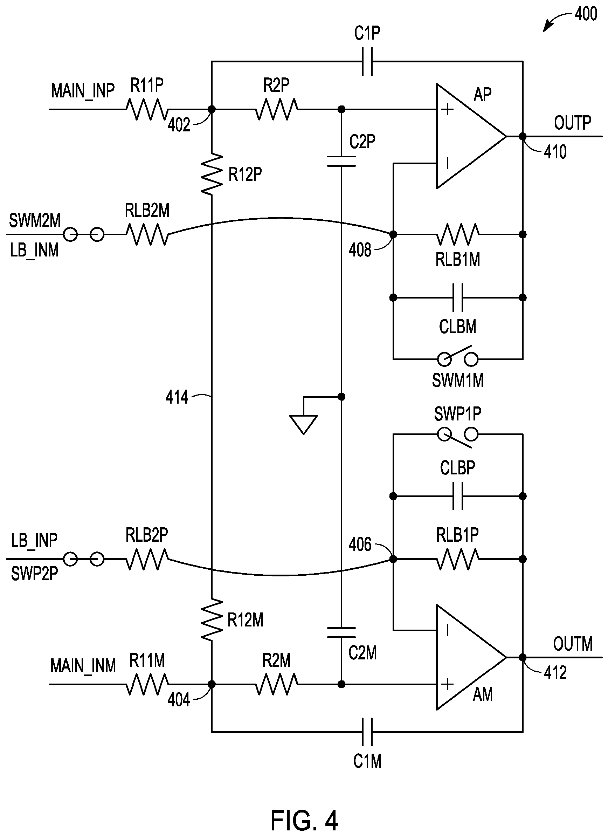

FIG. 4 illustrates generally an example of a second dual-input filter circuit 400. The second dual-input filter circuit 400 includes a first portion of the filter circuit that comprises a modified Sallen-Key topology with a first amplifier circuit AP, and a second portion that comprises a modified Sallen-Key topology with a second amplifier circuit AM. Inputs of the first and second portions are coupled by the resistive network that include resistors R12P and R12M coupled at a reference node 414. The second dual-input filter circuit 400 includes a main signal path configured to receive differential input signals MAIN_INP, MAIN_INM, and an auxiliary signal path configured to receive loop-back differential input signals LB_INP, LB_INM. Although the auxiliary signal path is sometimes referred to herein as receiving "loop-back" signals, the auxiliary signal path can be configured to receive any type of differential input signals. The differential main input signals can be coupled via input resistors R11P and R11M to a first intermediate node 402 and a second intermediate node 404, respectively.

The second dual-input filter circuit 400 includes the first and second amplifier circuits AP and AM with respective feedback networks. For example, a first feedback network for the first amplifier circuit AP comprises a parallel first resistor-capacitor (RC) circuit with a feedback resistor RLB1M and feedback capacitor CLBM. The first RC circuit can be bypassed or shunted using a first feedback switch SWM1M. When the first feedback switch SWM1M is closed, a first output node 410 of the first amplifier circuit AP is coupled to an inverting input terminal of the first amplifier circuit AP. A second feedback network for the second amplifier circuit AM comprises a parallel second RC circuit with a feedback resistor RLB1P and feedback capacitor CLBP. The second RC circuit can be bypassed or shunted using a second feedback switch SWP1P. When the second feedback switch SWP1P is closed, a second output node 412 of the second amplifier circuit AM is coupled to an inverting input terminal of the second amplifier circuit AM. In an example, the first and second feedback switches SWM1M and SWP1P are configured to operate together such that both switches are open or closed at the same time.

The second dual-input filter circuit 400 includes an auxiliary input path configured to receive differential loop-back input signals (LB_INP, LB_INM). A positive component of the loop-back input signals, LB_INP, can be coupled to a first loop-back input node 406 via a first loop-back input resistor RLB2P and a first input switch SWP2P, and a negative component of the loop-back input signals, LB_INM, can be coupled to second loop-back input node 408 via a second loop-back input resistor RLB2M and a second input switch SWM2M. In an example, the loop-back input resistors RLB2P, RLB2M can have relatively high resistance values (e.g., compared to the feedback resistors RLB1P, RLB1M, among others). This in turn relaxes on-resistance, capacitance, and other characteristic constraints on the implementation of the first and second input switches SWP2P, SWM2M.

The first and second input switches SWP2P, SWM2M can be configured to operate together such that both switches are open or closed at the same time. For example, when the first and second input switches SWP2P, SWM2M are open, then the second dual-input filter circuit 400 is in a first operating mode and loop-back signals are inhibited from reaching the first loop-back input node 406 and the second loop-back input node 408 of the second dual-input filter circuit 400. In the first operating mode, the first and second feedback switches SWM1M and SWP1P can be closed to shunt the amplifier circuit outputs to their corresponding respective inverting inputs.

When the first and second input switches SWP2P, SWM2M are closed, then the second dual-input filter circuit 400 is in a second operating mode and loop-back signals are provided to the first loop-back input node 406 and the second loop-back input node 408. In the second operating mode, the first and second feedback switches SWM1M and SWP1P can be open, and the first and second RC circuits can be provided as feedback paths for the first and second amplifier circuits, respectively. The illustrated example of FIG. 4 shows the second dual-input filter circuit 400 in the second operating mode with the first and second input switches SWP2P, SWM2M closed and the first and second feedback switches SWM1M and SWP1P open.

In the example of FIG. 4, the main input signal path passes through the first intermediate node 402 and the second intermediate node 404, while the auxiliary input signal path (e.g., the loop-back path) passes through the first loop-back input node 406 and the second loop-back input node 408. That is, the differential components of the auxiliary input signals can be conditioned and provided to respective different inputs of the filter amplifiers without interfering with the main input signal path. This configuration allows for each of the signal paths to be optimized independently.

For ease of initial discussion of the second dual-input filter circuit 400, the first and second feedback switches SWM1M and SWP1P, and the first and second input switches SWP2P and SWM2M, are assumed to be ideal. In the first or main operating mode, the first and second feedback switches SWM1M and SWP1P are closed or on, thereby shorting the first output node 410 of the first amplifier circuit AP to the second loop-back input node 408 and the inverting input node of the first amplifier circuit AP, and shorting the second output node 412 of the second amplifier circuit AM to the first loop-back input node 406 and the inverting input node of the second amplifier circuit AM. In this configuration, each of the first and second amplifier circuits AP and AM is configured for unity gain. In the first or main operating mode, the first and second input switches SWM2M and SWP2P are open or off, thereby disconnecting the loop-back inputs from the rest of the second dual-input filter circuit 400. The first or main operating mode of the second dual-input filter circuit 400 is thus functionally the same as the first or main operating mode of the first dual-input filter circuit 300, realizing a pseudo-differential unity gain Sallen-Key low-pass biquad anti-aliasing filter from the main inputs (e.g., MAIN_INP, MAIN_INM) to the filter outputs (OUTP, OUTM). For example, the output common-mode voltage is equal to the main input common-mode voltage. The main input differential signal is attenuated by *R*₁₂/(*R*₁₁ + *R*₁₂) at the output of the filter. The values of the passive components can be calculated using the equations above for desired cut-off frequency and noise performance targets.

In the second operating mode, or loop-back mode, the transfer function from the loop-back inputs to the filter outputs can be described as a first-order inverted lossy integrator. The loop-back input to filter output transfer function can have a 180 degree phase shift. Therefore, the negative component of the loop-back input (e.g., LB_INM) can be fed to the first amplifier circuit AP that is used to process the positive component of the main input (e.g., MAIN_INP), and the positive component of the loop-back input (e.g., LB_INP) can be fed to the second amplifier circuit AM that is used to process the negative component of the main input (e.g., MAIN_INM). In other words, the second dual-input filter circuit 400 implements a cross-coupled configuration for processing the loop-back signals. In the second operating mode, the negative component of the loop-back input signal (LB_INM) couples through switch SWM2M to the inverting input (at the second loop-back input node 408) of the first amplifier circuit AP, while the positive component of the loop-back input signal (LB_INP) couples through switch SWP2P to the inverting input (at the first loop-back input node 406) of the second amplifier circuit AM. This cross-coupling arrangement helps accommodate the 180-degree phase shift in the transfer function.

Ignoring the on-resistance of the switches in the second dual-input filter circuit 400, control over a gain (or attenuation) from the loop-back inputs to the filter outputs can be controlled using the resistors on the loop-back input signal path which can be independent of the resistors on the main input signal path. For example, the values of the feedback resistor RLB1M and the loop-back input resistor RLB2M can be changed to achieve a particular desired gain characteristic for the filter when the filter operates in the second mode. In an example, the feedback and loop-back resistors can have resistance values that are one or more orders of magnitude larger than the resistors used in the main signal path (e.g., R11P/R11M, R12P/R12M, and R2P, R2M). This in turn simplifies implementation of the first and second input switches SWM2M and SWP2P. In an example, capacitance characteristics of the feedback capacitors CLBM, CLBP can be selected to set a corner frequency for processing signals on the loop-back path of the second dual-input filter circuit 400, independently of the processing of signals on the main path.

The second dual-input filter circuit 400 is thus configured to operate in two distinct modes with optimized characteristics for each mode. During normal operation, the filter achieves high bandwidth up to half the sampling frequency while maintaining low-noise characteristics by using small resistor values (e.g., approximately 4kΩ) for each of R11P, R11M, R12P, R12M, and R2P, R2M. In the first operating mode, the main signal path maintains high linearity since signals pass through the positive input terminals of the amplifiers without interference from switching elements.

In the second or loop-back mode, the second dual-input filter circuit 400 preserves high linearity while operating through the negative input terminals of the amplifiers as inverting amplifiers. By providing the loop-back signals directly to the amplifier circuits via designated signal paths, current flow is reduced through the switches SWM2M and SWP2P by using substantially larger resistor values (e.g., approximately 100kΩ for RLB1M and RLB1P, and approximately 50kΩ for RLB2M and RLB2P). That is, the resistors used in the loop-back signal path can be several times larger than the resistors used in the main signal path. This simplifies switch design compared to prior approaches where switches carry large currents that can degrade filter linearity. While the second dual-input filter circuit 400 can exhibit higher noise for equivalent bandwidth settings, the bandwidth can be independently adjusted through feedback capacitor (e.g., CLBM, CLBP) tuning to achieve lower noise while maintaining linearity. During loop-back operation, the main inputs (MAIN_INP/MAIN_INM) are set to appropriate DC voltages to establish the desired common-mode voltage at the output.

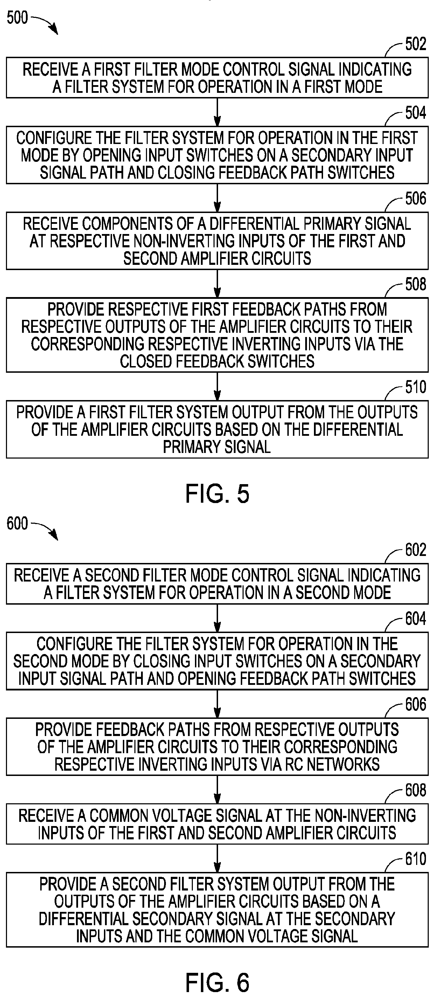

FIG. 5 illustrates generally an example of a first method 500 for operating a multiple-mode signal filter system. In an example, the filter system can include or use the second dual-input filter circuit 400 of FIG. 4. Although the example first method 500 depicts a particular sequence of operations, the sequence may be altered without departing from the scope of the present disclosure. In an example, the filter system is configured to selectively process signals from multiple respective signal inputs. The filter system can include, for example, an anti-aliasing signal filter. In an example, an output of the filter system is loaded by or coupled to an ADC circuit.

At operation 502, the first method 500 includes receiving a first filter mode control signal. The first filter mode control signal can indicate that the filter system is to operate in a first operating mode. In an example, in the first operating mode, the filter system is configured to process differential signals from a primary source. In a different second operating mode, the filter system can be configured to process differential signals from a secondary source.

At operation 504, the first method 500 includes configuring the filter system for operation in the first mode. In an example, operation 504 includes opening input switches on a secondary input path and closing feedback path switches. Opening the input switches on the secondary input path can decouple secondary inputs from the filter, and closing the feedback path switches can configure the filter system for signal processing according to specified first gain, bandwidth, and linearity characteristics.

At operation 506, the first method 500 includes receiving components of a differential primary signal at respective non-inverting inputs of first and second amplifier circuits of the filter system. In an example, the filter system comprises a portion of a test equipment system, and operation 506 includes receiving the differential primary signal from a device under test (DUT).

At operation 508, the first method 500 includes providing respective feedback paths from respective outputs of the amplifier circuits to their corresponding respective inverting inputs via the closed feedback path switches.

At operation 510, the first method 500 includes providing a first filter system output from the outputs of the amplifier circuits based on the differential primary signal received at operation 506. In an example, operation 510 includes providing the filter system output to an input of an ADC circuit.

FIG. 6 illustrates generally an example of a second method 600 for operating a multiple-mode signal filter system. In an example, the filter system can include or use the second dual-input filter circuit 400 of FIG. 4. Although the example second method 600 depicts a particular sequence of operations, the sequence may be altered without departing from the scope of the present disclosure. In an example, the filter system is configured to selectively process signals from multiple respective signal inputs. The filter system can include, for example, an anti-aliasing signal filter. In an example, an output of the filter system is loaded by or coupled to an ADC circuit.

At operation 602, the second method 600 includes receiving a second filter mode control signal. The second filter mode control signal can indicate that the filter system is to operate in a second operating mode. In an example, in the second operating mode, the filter system is configured to process differential signals from a secondary source. In an example, the second operating mode is a loop-back mode, and the secondary source comprises a DAC circuit that provides a differential signal to the filter system.

At operation 604, the second method 600 includes configuring the filter system for operation in the second mode. In an example, operation 604 includes closing input switches on a secondary input path and opening feedback path switches. Closing the input switches on the secondary input path can couple secondary inputs to the filter.

At operation 606, the second method 600 includes providing feedback paths from respective outputs of the amplifier circuits of the filter system to their corresponding respective inverting inputs via respective RC networks. In other words, operation 606 can insert a respective RC network as a feedback path for each of the amplifier circuits in the filter system. The values of the resistive and capacitive components in the feedback paths can be selected to influence gain, bandwidth, and linearity characteristics of the filter in the second operating mode. At operation 608, the second method 600 includes receiving a common (DC) voltage signal at the non-inverting inputs of the amplifier circuits in the filter system.

At operation 610, the second method 600 includes providing a second filter system output from the outputs of the amplifier circuits based on a differential secondary signal received at the secondary inputs and based on the common voltage signal received at the non-inverting inputs of the amplifier circuits. In an example, operation 610 includes providing the filter system output to an input of an ADC circuit.

### VARIOUS NOTES

Each of the non-limiting aspects or examples described herein may stand on its own, or may be combined in various permutations or combinations with one or more of the other examples discussed herein.

The above detailed description includes references to the accompanying drawings, which form a part of the detailed description. The drawings show, by way of illustration, specific embodiments in which the invention may be practiced. These embodiments are also referred to herein as "aspects" or "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of"at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

## Claims

1. A signal filter system comprising:
a first amplifier circuit with a non-inverting input, an inverting input, and an output;
an amplifier feedback network including a first switch, wherein the first switch is configured to selectively shunt the output of the first amplifier circuit to the inverting input of the first amplifier circuit;
a main signal input coupled to the non-inverting input of the first amplifier circuit via a first resistive network;
an auxiliary signal input coupled to the inverting input of the first amplifier circuit via a second switch;
wherein in a first filter mode: the first switch is closed, the second switch is open to decouple the auxiliary signal input from the inverting input of the first amplifier circuit, and an output signal at the output of the first amplifier circuit is a function of a main signal at the main signal input; and
wherein in a second filter mode: the first switch is open, the second switch is closed to couple the auxiliary signal input to the inverting input of the first amplifier circuit, and the output signal at the output of the first amplifier circuit is a function of an auxiliary signal at the auxiliary signal input and a voltage at the main signal input.

2. The signal filter system of claim 1, wherein the auxiliary signal input is coupled to the inverting input of the first amplifier circuit via the second switch and a second resistive network.

3. The signal filter system of claim 2, wherein one or more of the following apply:
a) resistors in the second resistive network have larger resistance values than resistors in the first resistive network;
b) the amplifier feedback network comprises the first switch in parallel with a first feedback capacitor and in parallel with a first resistor of the second resistive network; and/or
c) the second resistive network comprises:
a first resistor coupled in parallel with the first switch; and a second resistor coupled between the second switch and the inverting input of the first amplifier circuit

4. The signal filter system of any of claims 1 to 3, wherein the first resistive network comprises:
a first resistor coupled between the main signal input and an intermediate node;
a second resistor coupled to the intermediate node and a reference node; and
a third resistor coupled to the intermediate node and the non-inverting input of the first amplifier circuit.

5. The signal filter system of any of claims 1 to 4, wherein in the second filter mode, the main signal input is configured to receive a DC voltage selected to set a common-mode voltage at the output of the first amplifier circuit to match an input common-mode voltage of a loading circuit.

6. The signal filter system of any of claims 1 to 5, comprising:
a second amplifier circuit having a second non-inverting input coupled to a complementary main signal input and a second inverting input selectively coupled to a complementary auxiliary signal input, wherein respective outputs of the first amplifier circuit and the second amplifier circuit are configured to provide a differential output signal pair.

7. The signal filter system of claim 6, wherein one or more of the following apply:
a) the main signal input and the complementary main signal input are configured to receive a differential input signal pair from a digital-to-analog converter (DAC) circuit;
b) in the second filter mode, a voltage at the main signal input is equal to a voltage at the complementary main signal input; and/or
c) the system further comprises:
a second amplifier feedback network including a third switch, wherein the third switch is configured to selectively shunt the output of the second amplifier circuit to the inverting input of the second amplifier circuit; and a fourth switch coupled between the complementary auxiliary signal input and the inverting input of the second amplifier circuit; wherein in the first filter mode: the third switch is closed and the fourth switch is open; and wherein in the second filter mode: the third switch is open and the fourth switch is closed to couple the complementary auxiliary signal input to the inverting input of the second amplifier circuit.

8. A signal processing system comprising:
a first pair of differential input nodes configured to receive a primary differential signal;
a second pair of differential input nodes configured to receive a secondary differential signal; and
first and second amplifier circuits having respective non-inverting inputs, inverting inputs, and outputs;
wherein in a first filter mode: the non-inverting inputs are configured to receive respective components of the primary differential signal, the inverting inputs are shunted to their respective amplifier outputs, and a differential output signal from the respective outputs of the amplifier circuits is a function of the primary differential signal; and
wherein in a second filter mode: the non-inverting inputs are configured to receive respective voltage signals having a same voltage magnitude, the inverting inputs are configured to receive respective components of the secondary differential signal, and the differential output signal from the respective outputs of the amplifier circuits is a function of the secondary differential signal and the voltage signals at the non-inverting inputs.

9. The signal processing system of claim 8, comprising:
a first resistive network coupled between the first pair of differential input nodes and the non-inverting inputs of the amplifier circuits;
a first capacitive network coupled to the first resistive network to form a low-pass filter having a first cut-off characteristic; and
a second resistive network coupled between the second pair of differential input nodes and the inverting inputs of the amplifier circuits;
wherein resistance values of resistors in the first resistive network are less than resistance values of resistors in the second resistive network.

10. The signal processing system of any of claims 8 or 9, comprising an analog-to-digital converter (ADC) circuit, wherein the ADC circuit is configured to receive the differential output signal from the respective outputs of the amplifier circuits.

11. The signal processing system of claim 10, comprising a digital-to-analog converter (DAC) circuit, wherein the DAC circuit is configured to provide the secondary differential signal to the second pair of differential input nodes.

12. The signal processing system of any of claims 8 to 11, further comprising:
first and second switches coupled between the respective outputs and inverting inputs of the first and second amplifier circuits;
third and fourth switches coupled between the second pair of differential input nodes and the respective inverting inputs of the first and second amplifier circuits;
wherein the first and second switches are closed and the third and fourth switches are open in the first filter mode; and
wherein the first and second switches are open and the third and fourth switches are closed in the second filter mode.

13. A multiple-mode signal filtering method comprising:
in a first filter mode of a filter system, and with first switches closed and second switches opened:
receiving components of a differential primary signal at respective non-inverting inputs of first and second amplifier circuits;
providing respective first feedback paths from respective outputs of the amplifier circuits to their corresponding respective inverting inputs via the closed first switches; and
providing a first filter system output from outputs of the amplifier circuits based on the differential primary signal, wherein the opened second switches decouple secondary inputs to the respective inverting inputs of the first and second amplifier circuits;
and
in a second filter mode of the filter system, and with the first switches opened and the second switches closed, wherein the closed second switches couple the secondary inputs to the respective inverting inputs of the first and second amplifier circuits:
providing respective second feedback paths from the respective outputs of the amplifier circuits to their corresponding respective inverting inputs, wherein each of the second feedback paths comprises a resistor-capacitor (RC) network;
receiving a common voltage signal at the non-inverting inputs of the first and second amplifier circuits; and
providing a second filter system output from the outputs of the amplifier circuits based on a differential secondary signal at the secondary inputs and the common voltage signal.

14. The method of claim 13, wherein receiving the components of the differential primary signal includes receiving a differential output signal from a device under test (DUT).

15. The method of claim 13 or 14, comprising receiving the outputs of the amplifier circuits at an analog-to-digital converter (ADC) circuit, and optionally further comprising: using a digital-to-analog converter (DAC) circuit, providing a differential input signal to the second switches.
